# EUROPÄISCHE PATENTSCHRIFT

(11) **EP 2 165 374 B1**
(45) Veröffentlichungstag und Bekanntmachung des Hinweises auf die Patenterteilung: **17.08.2016**
(21) Anmeldenummer: 08773274.9
(22) Anmeldetag: 20.06.2008
(51) Int. Cl.: H01L 33/04, H01L 33/32, H01S 5/30, B82Y 20/00, H01L 33/06, H01S 5/343

(54) **STRAHLUNGSEMITTIERENDER HALBLEITERKÖRPER**
RADIATION-EMITTING SEMICONDUCTOR BODY
CORPS SEMI-CONDUCTEUR ÉMETTEUR DE RAYONNEMENT

(30) Priorität: 09.07.2007 DE 102007031926
(43) Veröffentlichungstag der Anmeldung: 24.03.2010
(73) Patentinhaber: OSRAM Opto Semiconductors GmbH, 93055 Regensburg (DE)
(72) Erfinder: STRASSBURG, Martin, 93105 Tegernheim (DE); HÖPPEL, Lutz, 93087 Alteglofsheim (DE); SABATHIL, Matthias, 93059 Regensburg (DE); PETER, Matthias, 93087 Alteglofsheim (DE); STRAUSS, Uwe, 93077 Bad Abbach (DE)
(74) Vertreter: Epping - Hermann - Fischer
(86) Internationale Anmeldenummer: PCT/DE2008/001039
(87) Internationale Veröffentlichungsnummer: WO 2009/006870

(56) Entgegenhaltungen:
- EP-A- 1 403 935
- EP-A- 1 748 496
- WO-A-2007/049939
- DE-A1-102004 050 891
- DE-A1-102005 035 722
- US-A1- 2003 151 042
- US-A1- 2004 079 947
- US-A1- 2004 101 012

## Beschreibung

Die Erfindung betrifft einen strahlungsemittierenden Halbleiterkörper.

Strahlungsemittierende Halbleiterkörper konventioneller Bauart zeigen eine Sättigung der im Betrieb emittierten Strahlungsleistung mit zunehmender Stromdichte eines im Betrieb in den Halbleiterkörper eingeprägten Betriebsstroms, so dass die Effizienz mit zunehmender Betriebsstromdichte sinkt.

US 2003/015042 offenbart einen strahlungsemittierenden Halbleiterkörper mit einer Tunnelstruktur. Die Tunnelstruktur ist zwischen einer n-typ Kontaktschicht und einer Multiquantentopfsttruktur ausgebildet. Die Tunnelstruktur weist eine n-typ Schicht, ein Zwischenschicht und eine p-typ Schicht auf.

Es ist eine Aufgabe der vorliegenden Erfindung einen strahlungsemittierenden Halbleiterkörper anzugeben, der bei großen Betriebsstromdichten eine verbesserte Effizienz aufweist.

Diese Aufgabe wird durch einen strahlungsemittierenden Halbleiterkörper gemäß Patentanspruch 1 gelöst. Vorteilhafte Ausgestaltungen und Weiterbildungen des Halbleiterkörpers sind in den abhängigen Ansprüchen angegeben, deren Offenbarungsgehalt hiermit ausdrücklich in die Beschreibung mit aufgenommen wird.

Ein strahlungsemittierender Halbeiterkörper gemäß der Erfindung weist eine aktive Zone auf. Die aktive Zone weist eine Mehrfachquantentopfstruktur auf, die zwei oder mehr aktive Schichten enthält, die bei Einprägen eines Betriebsstroms in den Halbleiterkörper elektromagnetische Strahlung emittieren.

Die aktive Zone basiert beispielsweise auf einem hexagonalen Verbindungshalbleitermaterial. "Auf einem hexagonalen Verbindungshalbleitermaterial basierend" bedeutet im vorliegenden Zusammenhang, dass die aktive Zone oder zumindest eine Schicht der aktiven Zone, insbesondere eine aktive Schicht, ein hexagonales Verbindungshalbleitermaterial aufweist. Das heißt, zumindest die aktive Zone weist eine hexagonale Gitterstruktur auf. Vorzugsweise basiert der gesamte Halbleiterkörper auf einem hexagonalen Verbindungshalbleitermaterial, dann weist das Halbleitermaterial des Halbleiterkörpers eine hexagonale Gitterstruktur auf.

Bei dem hexagonalen Verbindungshalbleitermaterial handelt es sich zum Beispiel um Halbleiterstrukturen aus binären, ternären und/oder quaternären Verbindungen von Elementen der II. und VI. Hauptgruppe des Periodensystems der chemischen Elemente. Beispielsweise kann es sich um eine der folgenden Verbindungen handeln: ZnO, ZnMgO, CdS, ZnCdS, MgBeO. Weiter kann es sich bei dem hexagonalen Verbindungshalbleitermaterial um eine Halbleiterstruktur aus einer binären, ternären und/oder quaternären Verbindung von Elementen der III. und V. Hauptgruppe, beispielsweise um ein Nitrid handeln. Es kann sich zum Beispiel um eine der folgenden Halbleiterstrukturen handeln: BN, AlGaN, GaN, AlInGaN.

Dabei muss das Halbleitermaterial nicht zwingend eine mathematisch exakte Zusammensetzung nach einer der obigen Formeln aufweisen, vielmehr kann es einen oder mehrere Dotierstoffe sowie zusätzliche Bestandteile aufweisen. Der Einfachheit halber beinhalten obige Formeln jedoch nur die wesentlichen Bestandteile des Kristallgitters, auch wenn diese teilweise durch geringere Mengen weiterer Stoffe ersetzt sein können.

Bei einem hexagonalen Verbindungshalbleiter - beispielsweise bei einem auf dem III-V-Halbleitermaterialsystem AlInGaN, also AlₓIn_{y}Ga_{1-x-y}N mit 0 ≤ x ≤ 1, 0 ≤ y ≤ 1 und x + y ≤ 1, basierenden Halbleiterkörper -treten in der aktiven Zone, die beispielsweise InGaN-Quäntentröge umfassen kann, piezoelektrische Felder aufgrund der polaren Wurtzit-Kristallstruktur und der Verspannung in der aktiven Zone auf.

Diese piezoelektrischen Felder sind entlang der Wachstumsrichtung ausgerichtet. Die Polung dieser Felder ist abhängig vom Wachstumsmodus, in dem der Halbleiterkörper gewachsen wird. Beispielsweise bei Verwendung der metallorganischen Gasphasenepitaxie (MOVPE) wird bevorzugt im sogenannten Ga-Face Wachstumsmodus gewachsen. Beispielsweise für einen GaN Kristall bedeutet dies, dass bei den Ga-N Doppelschichten, aus denen der Kristall gebildet ist, die Galliumatome in Richtung der vom Wachstumssubstrat abgewandten Oberfläche des Kristalls liegen. Die kristallographische c-Achse und das elektrische Feld zeigen bei im Ga-Face Wachstumsmodus gewachsenen Kristallen, bei denen die Wachstumsrichtung parallel zur kristallographischen c-Achse verläuft, vom Substrat weg zur Kristalloberfläche.

Die Polarisation der piezoelektrischen Felder aufgrund der Verspannungen in der aktiven Zone hat die entgegen gesetzte Richtung. Die durch die Polarisation induzierten Gitterladungen sind negativ an der der Kristalloberfläche zugewandten Seite des aktiven Bereichs und positiv an der der Schnittstelle von Substrat und aufgewachsenem Kristall zugewandten Seite des aktiven Bereichs. Die Polung der piezoelektrischen Felder in Richtung der c-Achse lässt sich im Ga-face Wachstumsmodus nur schwer beeinflussen.

Bei einer vorteilhaften Ausgestaltung des optoelektronischen Halbleiterkörpers folgen in Wachstumsrichtung, das heißt parallel zur kristallographischen c-Achse, eine p-dotierte Einschlussschicht, die aktive Zone und eine n-leitende Einschlussschicht in dieser Reihenfolge aufeinander. Die p-dotierte Einschlussschicht und die n-leitende Einschlussschicht sind Halbleiterschichten des Halbleiterkörpers, die der aktiven Zone in Wachstumsrichtung vorausgehen oder nachfolgen. Bei einer Weiterbildung stellt die p-dotierte Einschlussschicht und/oder die n-leitende Einschlussschicht eine Ladungsträger-Einschlussschicht ("Confinement Layer") und/oder eine Mantelschicht ("cladding layer") dar. Eine Mantelschicht ist insbesondere, etwa aufgrund ihres Brechungsindex, in einer dem Fachmann grundsätzlich bekannten Weise zur Führung einer von der aktiven Zone im Betrieb emittierten elektromagnetischen Strahlung vorgesehen.

Bei einer Abfolge von Schichten um den aktiven Bereich, bei der in Wachstumsrichtung die n-leitende Einschlussschicht, die aktive Zone und die p-dotierte Einschlussschicht in dieser Reihenfolge aufeinander folgen, führen die piezoelektrischen Felder zu einer ungünstigen energetischen Barrierenstruktur, die die Injektion von Ladungsträgern in den aktiven Bereich erschwert. Solche optoelektronischen Halbleiterkörper weisen daher eine interne Quanteneffizienz auf, die oft nicht zufriedenstellend ist und insbesondere mit steigender Stromdichte stark abfällt.

Derzeit wird von den Erfindern angenommen, dass gegenüber solchen Halbleiterkörpern das Gebiet, in dem eine Rekombination von Elektronen und Löchern im Betrieb erfolgt, mit Vorteil verbreitert ist, wenn in Wachstumsrichtung die p-dotierte Einschlussschicht, die aktive Zone und die n-leitende Einschlussschicht in dieser Reihenfolge aufeinanderfolgen. In dem Gebiet, in dem eine Rekombination von Elektronen und Löchern im Betrieb erfolgt, also in der Rekombinationszone, sind mindestens zwei aktive Schichten der Mehrfachquantentopfstruktur angeordnet und emittieren im Betrieb des Halbleiterkörpers elektromagnetische Strahlung.

Bei einer zweckmäßigen Ausgestaltung weist der Halbleiterkörper eine Kontaktschicht auf. Bei der Kontaktschicht handelt es sich insbesondere um eine Halbleiterschicht des Halbleiterkörpers, durch die hindurch im Betrieb des Halbleiterkörpers ein Betriebsstrom in die aktive Zone eingeprägt wird. Sie weist vorzugsweise eine gute elektrische Leitfähigkeit, insbesondere eine gute elektrische Querleitfähigkeit auf. Bei einer Ausgestaltung handelt es sich bei der Kontaktschicht um eine epitaktisch auf dem Wachstumssubstrat hergestellte Halbleiterschicht. Alternativ kann die Kontaktschicht auch im Wachstumssubstrat enthalten oder von diesem gebildet sein.

Bei einer Ausführungsform ist die Kontaktschicht eine p-Kontaktschicht, die insbesondere zwischen dem Wachstumssubstrat und der aktiven Zone angeordnet ist. Zweckmäßigerweise folgen in Wachstumsrichtung bei dieser Ausführungsform die p-Kontaktschicht, die p-dotierte Einschlussschicht, die aktive Zone, die n-leitende Einschlussschicht und eine weitere Kontaktschicht, die insbesondere eine n-Kontaktschicht ist, aufeinander. Bei einer Variante stellt eine p-dotierte Halbleiterschicht zugleich die p-Kontaktschicht und die p-dotierte Einschlussschicht dar. Analog kann eine n-leitende Halbleiterschicht zugleich die n-Kontaktschicht und die n-leitende Einschlussschicht darstellen. Bei einer weiteren Variante sind das Wachstumssubstrat und die p-Kontaktschicht integriert ausgebildet.

Bei einer anderen Variante ist das Wachstumssubstrat stark gedünnt oder vollständig von dem Halbleiterkörper entfernt. In diesem Fall kann die Wachstumsrichtung in der Regel anhand der Abfolge der Atomlagen im Halbleiterkörper bestimmt werden. Ist das Kristallwachstum im Ga-Face Wachstumsmodus erfolgt, beträgt in Wachstumsrichtung der Abstand von der Ga-Ebene zur N-Ebene etwa drei Mal so viel wie der Abstand von der N-Ebene zur Ga-Ebene. Es ist grundsätzlich zwar möglich, die Materialien im N-Face Wachstumsmodus herzustellen, d.h. bezogen auf die Gitterstruktur in umgekehrter Richtung oder Reihenfolge aufzuwachsen. In dieser Richtung beträgt der Abstand von der N-Ebene zur Ga-Ebene etwa drei Mal so viel wie der Abstand von der Ga-Ebene zur N-Ebene. Um die Materialien im N-Face Wachstumsmodus aufzuwachsen, sind in der Regel jedoch besondere Maßnahmen nötig.

Bei einer alternativen Ausführungsform ist die Kontaktschicht eine n-Kontaktschicht. Beispielsweise ist die n-Kontaktschicht auf dem Wachstumssubstrat abgeschieden und geht der aktiven Zone in Wachstumsrichtung voraus oder das Wachstumssubstrat weist die n-Kontaktschicht auf.

Zwischen der n-Kontaktschicht und der aktiven Zone weist der Halbleiterkörper bei einer zweckmäßigen Ausgestaltung einen Tunnelübergang auf. Mittels des Tunnelübergangs wird mit Vorteil eine Abfolge der Halbleiterschichten des Halbleiterkörpers erzielt, bei der in Wachstumsrichtung, das heißt parallel zur kristallographischen c-Achse, die p-dotierte Einschlussschicht der n-Kontaktschicht nachfolgt und der aktiven Zone vorausgeht und die n-leitende Einschlussschicht der aktiven Zone nachfolgt.

Bei einer bevorzugten Ausgestaltung des Halbleiterkörpers ist zwischen zwei aktiven Schichten, insbesondere zwischen je zwei benachbarten aktiven Schichten, eine Barriereschicht angeordnet. Bei einer vorteilhaften Weiterbildung hat die Barriereschicht eine Schichtdicke von kleiner oder gleich 9 nm, vorzugsweise beträgt die Schichtdicke der Barriereschicht 4 nm oder weniger. Vorzugsweise folgen die aktiven Schichten und die Barriereschicht(en) unmittelbar aufeinander. Die Quantentöpfe der Mehrfachquantentopfstruktur sind insbesondere von den aktiven Schichten, der/den Barriereschicht(en) und den Abschluss-Barriereschichten gebildet.

Bei einer weiteren Ausgestaltung des Halbleiterkörpers weist die aktive Zone drei oder mehr aktive Schichten auf. Bei einer Weiterbildung weist sie fünf oder weniger aktive Schichten auf.

Die Erfinder haben festgestellt dass mit einer derartigen Barriereschicht beziehungsweise derartigen Barriereschichten eine Anordnung von mindestens zwei der aktiven Schichten in der Rekombinationszone erzielt wird. Beispielsweise sind 3 oder mehr und insbesondere 5 oder weniger aktive Schichten der Mehrfachquantentopfstruktur in der Rekombinationszone angeordnet.

Die Erfinder haben weiter festgestellt, dass mittels einer derartigen Barriereschicht beziehungsweise mittels derartiger Barriereschichten, die eine Schichtdicke von 9 nm oder weniger und insbesondere von 4 nm oder weniger aufweist/aufweisen, eine elektronische Kopplung zwischen den einzelnen aktiven Schichten erzielt wird. Derzeit wird von den Erfindern angenommen, dass auf diese Weise beispielsweise resonantes Tunneln von Ladungsträgern zwischen den einzelnen aktiven Schichten auftritt. Dies führt vorteilhafterweise insbesondere bei hohen Stromdichten eines in den Halbleiterkörper im Betrieb eingeprägten Betriebsstroms zu einer vorteilhaften Ladungsträgerverteilung auf die einzelnen, in der Rekombinationszone angeordneten aktiven Schichten, so dass eine hohe Effizienz erzielt wird.

Bei einem Halbleiterkörper mit Tunnelübergang beeinflusst auch der Tunnelübergang den Potentialverlauf in der aktiven Zone. Zum einen werden für die Ladungsträger die energetischen Barrieren für die Injektion in die aktive Zone abgesenkt. Zum anderen konnte von den Erfindern gezeigt werden, dass die effektive Dicke der Quantentöpfe der Mehrfachquantentopfstruktur vorteilhafterweise besonders klein ist. Beispielsweise ist die effektive Dicke der Quantentöpfe kleiner oder gleich 1 nm.

Zusammenfassend wurde festgestellt, dass die Kombination einer invertierten Polarität des Betriebsstroms relativ zur Wachstumsrichtung mit einer Mehrfachquantentopfstruktur, die Barriereschichten mit einer geringen Schichtdicke enthält, einen Halbleiterkörper ermöglicht, bei dem mindestens zwei und insbesondere mindestens drei aktive Schichten der Mehrfachquantentopfstruktur zur Strahlungsemission beitragen und der bei hohen Betriebsströmen eine besonders große Effizienz aufweist. Die invertierte Polarität des Betriebsstroms relativ zur Wachstumsrichtung ist insbesondere mittels des Tunnelübergangs erzielt.

Der Tunnelübergang weist mindestens eine n-Typ Tunnelübergangsschicht und mindestens eine p-Typ Tunnelübergangsschicht auf.

Zwischen der mindestens einen n-Typ Tunnelübergangsschicht und der mindestens einen p-Typ Tunnelübergangsschicht ist ein undotierter Bereich aus mindestens einer undotierten Zwischenschicht enthalten. In dem Tunnelübergang grenzen die n-Typ Tunnelübergangsschichten und die p-Typ Tunnelübergangsschicht also nicht direkt aneinander an, sondern sind durch die mindestens eine undotierte Zwischenschicht voneinander separiert. Der Begriff "Tunnelübergangsschicht" wird dabei zur Unterscheidung von den übrigen Halbleiterschichten des Halbleiterkörpers verwendet und bedeutet, dass die so bezeichnete n-Typ Tunnelübergangsschicht oder p-Typ Tunnelübergangsschicht in dem Tunnelübergang angeordnet ist.

Dadurch, dass die n-Typ Tunnelübergangsschicht und die p-Typ Tunnelübergangsschicht durch den undotierten Bereich voneinander separiert sind, wird eine nachteilige Kompensation der unterschiedlichen Ladungsträger an der Grenzfläche verhindert, die ansonsten aufgrund der Diffusion von Ladungsträgern und/oder Dotierstoffen über die Grenzfläche hinweg auftreten würde.

Zwar wird auch durch das Einfügen des undotierten Bereichs zwischen der n-Typ Tunnelübergangsschicht und der p-Typ Tunnelübergangsschicht ein Bereich mit einer nur geringen Ladungsträgerdichte innerhalb des Tunnelübergangs erzeugt. Es wurde im Zusammenhang mit der vorliegenden Anmeldung jedoch festgestellt, dass sich dieser Bereich weniger nachteilig auf die elektrischen Eigenschaften des Tunnelübergangs, insbesondere auf die Vorwärtsspannung, auswirkt. Insbesondere wirkt sich der in Form von einer oder mehreren undotierten Zwischenschichten eingefügte undotierte Bereich weniger nachteilig aus als ein Bereich an der Grenzfläche zwischen einer n-Typ Tunnelübergangsschicht und einer unmittelbar angrenzenden p-Typ Tunnelübergangsschicht, in dem sich Ladungsträger und/oder Dotierstoffe aufgrund der Diffusion über die Grenzfläche gegenseitig kompensieren. Dies ist insbesondere dann für den Betrieb des Halbleiterkörpers wichtig, wenn dieser mit einem Betriebsstrom betrieben wird, der eine hohe Stromdichte in dem Halbleiterkörper hervorruft.

Bei einer weiteren vorteilhaften Ausgestaltung folgen mindestens die folgenden Halbleiterschichten in der angegebenen Reihenfolge in Wachstumsrichtung aufeinander: Die n-Kontaktschicht, der Tunnelübergang, wobei vorzugsweise die mindestens eine p-Typ Tunnelübergangsschicht dem undotierten Bereich und dieser der mindestens einen n-Typ Tunnelübergangsschicht in Wachstumsrichtung nachfolgt, eine p-dotierte Einschlussschicht, die aktive Zone, und eine weitere n-Kontaktschicht.

Der undotierte Bereich des Tunnelübergangs weist mindestens zwei undotierte Zwischenschichten mit unterschiedlicher Zusammensetzung auf. Beispielsweise weist er eine von der aktiven Zone entfernte GaN-Schicht und eine der aktiven Zone benachbarte AlGaN-Schicht auf.

Die Dicke des undotierten Bereichs beträgt beispielsweise zwischen 0,5 und 15 nm, insbesondere zwischen 1 und 10 nm, wobei die Grenzen jeweils eingeschlossen sind. Bei einer derartigen Dicke stellt der undotierte Bereich eine Barriere für die in der n-Typ Tunnelübergangsschicht und der p-Typ Tunnelübergangsschicht jeweils vorhandenen Ladungsträger dar, die eine gegenseitige Kompensation der Ladungen vermindert. Andererseits ist der undotierte Bereich noch dünn genug, um sich nicht nachteilig auf die elektronischen Eigenschaften des Tunnelübergangs auszuwirken.

Bei einer weiteren vorteilhaften Ausgestaltung enthält die n-Typ Tunnelübergangsschicht und/oder die p-Typ Tunnelübergangsschicht ein Übergitter aus alternierenden Schichten mit unterschiedlicher Materialzusammensetzung und/oder Dotierstoffkonzentration.

Bei einer anderen Ausgestaltung ist zwischen der p-dotierten Schicht und der aktiven Zone eine Diffusionsbarriere für den p-Dotierstoff der p-dotierten Schicht angeordnet. Die Diffusionsbarriere enthält bei einer Weiterbildung ein Übergitter.

Bei einer weiteren Ausgestaltung enthält der strahlungsemittierende Halbleiterkörper an der von dem Tunnelübergang abgewandten Seite der aktiven Zone eine undotierte Halbleiterschicht. Zum Beispiel stellt die undotierte Halbleiterschicht eine n-leitende Einschlussschicht dar. Zweckmäßigerweise ist die undotierte Halbleiterschicht zwischen der aktiven Zone und einer weiteren Kontaktschicht des Halbleiterkörpers angeordnet.

Die undotierte Halbleiterschicht hat zum Beispiel eine Schichtdicke zwischen 3 und 40 nm. Im Gegensatz zu konventionellen Halbleiterkörpern beeinflusst die Schichtdicke der undotierten Halbleiterschicht die Effizienz des Halbleiterkörpers nicht oder nur geringfügig. Die Schichtdicke kann daher mit Vorteil praktisch beliebig gewählt werden und ermöglicht größere Toleranzen bei der Herstellung des Halbleiterkörpers. Bei einer vorteilhaften Ausgestaltung ist der Halbleiterkörper zum Betrieb mit einer Betriebsstromdichte von größer oder gleich 100 A/cm², insbesondere von größer oder gleich 300 A/cm² vorgesehen. Bei einer Weiterbildung ist der Halbleiterkörper zum Betrieb mit noch höheren Betriebsstromdichten vorgesehen, etwa zum Betrieb mit Betriebsstromdichten von 500 A/cm² oder mehr, von 1000 A/cm² oder von 2000 A/cm² oder mehr.

Der Halbleiterkörper emittiert im Betrieb elektromagnetische Strahlung mit einer spektralen Verteilung, die ein Intensitätsmaximum aufweist. Beispielsweise hat das Intensitätsmaximum eine Wellenlänge im infraroten, sichtbaren oder ultravioletten Spektralbereich. Die Halbwertsbreite der spektralen Verteilung ist im Wesentlichen unabhängig von der Stromstärke des Betriebsstroms. Entsprechend der mathematischen Definition wird unter der Halbwertsbreite vorliegend die Differenz der beiden Wellenlängen verstanden, bei denen die Intensität, ausgehend von der Wellenlänge des Intensitätsmaximums zu größeren und zu kleineren Wellenlängen, auf die Hälfte der Intensität am Intensitätsmaximum abgesunken ist.

Bei dem Halbleiterkörper kann es sich um einen Leuchtdiodenchip oder um einen Laserdiodenchip, insbesondere um einen kantenemittierenden Laserdiodenchip, handeln.

Bei einer weiteren Ausgestaltung enthält der Halbleiterkörper mindestens eine weitere aktive Zone. Die aktiven Zonen folgen bei dieser Ausgestaltung in Wachstumsrichtung aufeinander. Beispielsweise enthält der Halbleiterkörper zwischen drei und zehn aktiven Zonen. Zwischen je zwei benachbarten aktiven Zonen ist zweckmäßigerweise ein weiterer Tunnelübergang angeordnet. Die weitere(n) aktive(n) Zone(n) und/oder der weitere Tunnelübergang / die weiteren Tunnelübergänge sind vorzugsweise analog zu einer Ausgestaltung ausgeführt, für die aktive Zone oder den Tunnelübergang vorstehend beschrieben ist.

Beispielsweise enthält der Halbleiterkörper die folgenden Halbleiterschichten in der angegebenen Reihenfolge: die p-dotierte Einschlussschicht, die aktive Zone, die n-leitende Einschlussschicht, den weiteren Tunnelübergang, eine weitere p-dotierte Einschlussschicht, die weitere aktive Zone, eine weitere n-leitende Einschlussschicht. Bei einer Weiterbildung geht der p-dotierten Einschlussschicht der Tunnelübergang voraus. Bei einer anderen Weiterbildung folgt der weiteren n-leitenden Einschlussschicht die weitere n-Kontaktschicht nach. Zwischen der weiteren p-dotierten Einschlussschicht und der weiteren aktiven Zone kann eine weitere Diffusionsbarriere angeordnet sein.

Weitere Vorteile und vorteilhafte Ausführungsformen ergeben sich aus den folgenden, in Verbindung mit den Figuren 1 bis 11 beschriebenen Ausführungsbeispielen.

Es zeigen:
- Figur 1,: einen schematischen Querschnitt durch einen Halbleiterkörper gemäß einem Ausführungsbeispiel,
- Figur 2,: einen schematischen Querschnitt durch den Tunnelübergang des Halbleiterkörpers gemäß dem Ausführungsbeispiel der Figur 1,
- Figur 3,: einen schematischen Querschnitt durch die Diffusionsbarriere des Halbleiterkörpers gemäß dem Ausführungsbeispiel der Figur 1,
- Figur 4,: einen schematischen Querschnitt durch einen Halbleiterkörper gemäß einem weiteren Ausführungsbeispiel,
- Figur 5A,: eine schematische Darstellung der Bandstruktur einer konventionellen Mehrfachquantentopfstruktur,
- Figur 5B,: eine schematische Darstellung der Mehrfachquantentopfstruktur gemäß dem Ausführungsbeispiel der Figur 1,
- Figur 6,: die Abhängigkeit der emittierten Strahlungsleistung vom Betriebsstrom bei dem Halbleiterkörper gemäß dem Ausführungsbeispiel der Figur 1 im Vergleich zu weiteren Halbleiterkörpern,
- Figur 7,: eine schematische Darstellung der Linearität der emittierten Strahlungsleistung in Abhängigkeit von der Schichtdicke der Barriereschicht bei dem Halbleiterkörper gemäß dem Ausführungsbeispiel der Figur 1 im Vergleich zu einem weiteren Halbleiterkörper,
- Figur 8,: die Halbwertsbreite der spektralen Verteilung in Abhängigkeit vom Betriebsstrom bei dem Halbleiterkörper gemäß dem Ausführungsbeispiel der Figur 1 im Vergleich zu weiteren Halbleiterkörpern,
- Figur 9,: die Wellenlänge des Emissionsmaximums in Abhängigkeit vom Betriebsstrom bei dem Halbleiterkörper gemäß dem Ausführungsbeispiel der Figur 1 im Vergleich zu weiteren Halbleiterkörpern,
- Figur 10,: die Abhängigkeit der Intensität der von dem Halbleiterkörper gemäß dem Ausführungsbeispiel der Figur 1 emittierten elektromagnetischen Strahlung vom Betriebsstrom bei verschiedenen Schichtdicken der Barriereschicht,
- Figur 11,: die Abhängigkeit der Strahlungsleistung der von dem Halbleiterkörper gemäß dem Ausführungsbeispiel der Figur 1 emittierten elektromagnetischen Strahlung vom Betriebsstrom bei verschiedenen Anzahlen von aktiven Schichten, und
- Figur 12,: die relative Intensität der emittierten elektromagnetischen Strahlung in Abhängigkeit von der Schichtdicke der undotierten Halbleiterschicht bei dem Halbleiterkörper gemäß dem Ausführungsbeispiel der Figur 1 im Vergleich zu einem weiteren Halbleiterkörper.

In den Ausführungsbeispielen und Figuren sind gleiche oder gleich wirkende Bestandteile mit den gleichen Bezugszeichen versehen. Die Figuren und insbesondere die Größenverhältnisse der einzelnen, in den Figuren dargestellten Elemente sind nicht als maßstabsgerecht anzusehen. Vielmehr können einzelne Bestandteile, wie etwa Schichten, zur besseren Darstellbarkeit und/oder zum besseren Verständnis übertrieben groß beziehungsweise dick dargestellt sein.

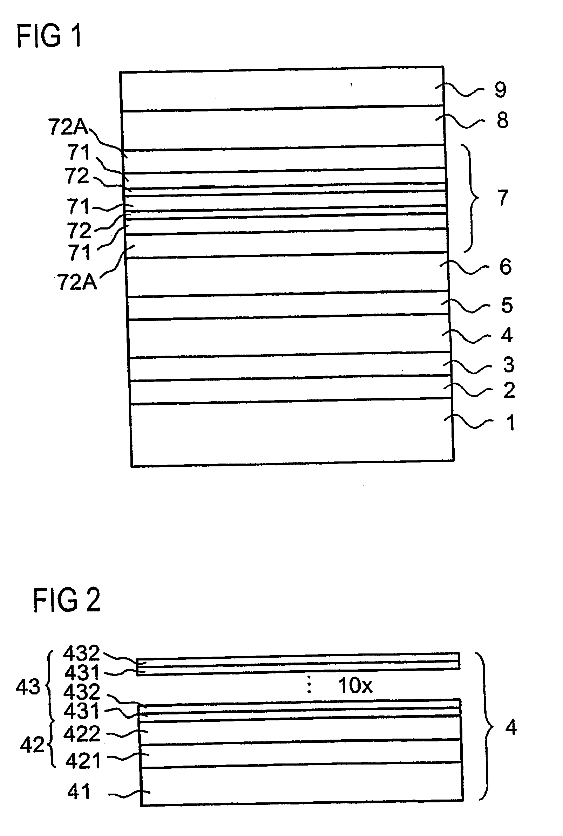

In Figur 1 ist ein Ausführungsbeispiel eines strahlungsemittierenden Halbleiterkörpers gezeigt. Der Halbleiterkörper weist eine Halbleiterschichtenfolge auf, die vorzugsweise auf einem hexagonalen Verbindungshalbleitermaterial basiert, insbesondere auf einem Nitrid-III-Verbindungshalbleitermaterial. Besonders bevorzugt handelt es sich bei dem Nitrid-III-Verbindungshalbleitermaterial um AlInGaN, also AlₓIn_{y}Ga_{1-x-y}N mit 0 ≤ x ≤ 1, 0 ≤ y ≤ 1 und x+y ≤ 1.

Der Halbleiterkörper weist ein Substrat 1 auf, das insbesondere ein zum Aufwachsen eines derartigen Nitrid-III-Verbindungshalbleiters geeignetes Material, zum Beispiel GaN, SiC und/oder Saphir enthält oder aus daraus besteht. Das Substrat ist bevorzugt n-leitend und enthält zum Beispiel n-GaN, n-SiC und/oder n-Si(111) oder besteht aus mindestens einem dieser Materialien.

Auf dem Substrat 1 kann, wie in Figur 1 gezeigt, eine Pufferschicht 2 aufgebracht sein, beispielsweise zur Anpassung der Gitterparameter zwischen dem Substrat 1 und den nachfolgenden Halbleiterschichten. Die Pufferschicht besteht beispielsweise aus GaN oder AlGaN, also AlₓGa₁₋ₓN mit 0 ≤ x ≤ 1. Insbesondere hat sie eine Dicke zwischen 20 nm und 1500 nm, wobei die Grenzen eingeschlossen sind.

Nachfolgend auf das Substrat 1 beziehungsweise gegebenenfalls auf die Pufferschicht 2 ist eine n-Kontaktschicht 3 angeordnet, etwa eine n-leitende und insbesondere n-dotierte GaN-Schicht, AlGaN-Schicht oder AlInGaN-Schicht. Vorliegend ist die n-Kontaktschicht 3 mit Si in einer Konzentration zwischen 10¹⁸ cm⁻³ und 10²⁰ cm⁻³, insbesondere zwischen 2x10¹⁸ cm⁻³ und 10¹⁹ cm⁻³ n-dotiert, wobei die Grenzen jeweils eingeschlossen sind. Der n-Kontaktschicht folgt ein Tunnelübergang 4 nach.

Vorzugsweise handelt es sich bei dem Tunnelübergang 4 um einen hoch dotierten n-p-Tunnelübergang. Unter einer hohen Dotierung wird vorliegend eine Dotierung von größer oder gleich 10¹⁹ cm⁻³, insbesondere von größer oder gleich 10²⁰ cm⁻³ verstanden. Dabei ist die n-dotierte Seite des Tunnelübergangs 4 der n-Kontaktschicht 3 zugewandt und die p-dotierte Seite ist von der n-Kontaktschicht 3 abgewandt.

Wie in Figur 2 dargestellt, enthält der Tunnelübergang 4 vorliegend eine n-Typ Tunnelübergangsschicht 41 und eine p-Typ Tunnelübergangsschicht 43, die der n-Typ Tunnelübergangsschicht 41 in Wachstumsrichtung nachfolgt. Die p-Typ Tunnelübergangsschicht 43 und/oder die n-Typ Tunnelübergangsschicht 41 weisen bei dem hoch dotierten n-p-Tunnelübergang 4 eine hohe Dotierung auf.

Die p-Typ Tunnelübergangsschicht 43 ist vorliegend als Mehrschichtsystem ausgeführt. Sie enthält ein Übergitter aus alternierenden Schichten 431 und 432. Vorliegend enthält das Übergitter zehn Paare von Schichten 431, 432. Beispielsweise enthält das Übergitter hoch p-dotierte InGaN -Schichten 431 und undotierte GaN-Schichten 432, wobei InGaN für InₓGa₁₋ₓN mit 0 ≤ x ≤ 1 steht.

Die Schichtdicke der einzelnen Schichten des Übergitters 431, 432 beträgt vorzugsweise 2 nm oder weniger, besonders bevorzugt 1 nm oder weniger. Vorliegend beträgt die Schichtdicke der Schichten 431 und 432 jeweils 0,5 nm. Die p-Typ Tunnelübergangsschicht 43 hat demnach vorzugsweise eine Dicke von 40 nm oder weniger, besonders bevorzugt von 20 nm oder weniger. Vorliegend hat die p-Typ Tunnelübergangsschicht 43 eine Schichtdicke von 10 nm.

In analoger Weise kann auch die n-Typ Tunnelübergangsschicht 41 als Mehrschichtsystem aufgebaut sein. Beispielsweise weist die n-Typ Tunnelübergangsschicht 41 bei einer Ausgestaltung ein Übergitter aus alternierenden hoch n-dotierten Schichten und undotierten Schichten auf. Beispielsweise handelt es sich bei den n-dotierten Schichten um InGaN-Schichten und bei den undotierten Schichten um GaN-Schichten. Besonders bevorzugt handelt es sich um eine kurzperiodische Übergitterstruktur, die eine Periode von 10 nm oder weniger, bevorzugt von 5 nm oder weniger, insbesondere von 2 nm oder weniger aufweist. Die Schichtdicke der Schichten des Übergitters beträgt beispielsweise 0,5 Nanometer. Die Anzahl der Perioden ist vorzugsweise kleiner oder gleich 15.

Die Ausbildung der n-Typ Tunnelübergangsschicht 41 und/oder der p-Typ-Tunnelübergangsschicht 43 als Übergitter hat den Vorteil, dass dadurch die Morphologie der Kristallstruktur im Vergleich zu einer hoch dotierten Einzelschicht verbessert ist. Insbesondere ist durch die Vielzahl der in der Übergitterstruktur enthaltenen Grenzflächen die Ausbreitung von Versetzungen in dem Halbleiterkörper vermindert.

Bei dem in Figur 2 dargestellten Ausführungsbeispiel des Tunnelübergangs 4 ist zwischen der n-Typ Tunnelübergangsschicht 41 und der p-Typ Tunnelübergangsschicht 43 ein undotierter Bereich 42 angeordnet. Der undotierte Bereich 42 hat den Vorteil, dass die n-Typ Tunnelübergangsschicht 41 und die p-Typ Tunnelübergangsschicht 43, die üblicherweise jeweils eine hohe Dotierung aufweisen, nicht unmittelbar aneinander grenzen. Auf diese Weise wird einer Diffusion der unterschiedlichen Ladungsträgertypen in die jeweilige hoch dotierte Schicht mit entgegen gesetzter Dotierung entgegengewirkt und eine Kompensation der Ladungsträger verringert.

Vorteilhafterweise verbessert der undotierte Bereich 42 die elektronischen Eigenschaften des Tunnelübergangs 4. Insbesondere wird eine vergleichsweise geringe Vorwärtsspannung erzielt. Beispielsweise beträgt die Vorwärtsspannung 5 V des Halbleiterkörpers oder weniger.

Der undotierte Bereich 42 enthält vorzugsweise AlₓGa₁₋ₓN mit 0 ≤ x ≤ 1 oder AlₓIn_{y}Ga₁₋ₓN mit 0 s x s 1, 0 ≤ y ≤ 1 und x + y ≤ 1. Bevorzugt gilt für den Aluminiumanteil 0,05 ≤ x ≤ 0,3. Eine AlGaN-Schicht ist besonders gut als Diffusionsbarriere geeignet, wenn die p-Typ Tunnelübergangsschicht Magnesium als p-Dotierstoff enthält. Bei dem n-Dotierstoff der n-Typ Tunnelübergangsschicht 41 handelt es sich beispielsweise um Silizium.

Vorzugsweise stellt der undotierte Bereich 42 eine Mehrschichtstruktur mit mindestens zwei undotierten Zwischenschichten 421, 422 dar. Beispielsweise handelt es sich bei der ersten undotierten Zwischenschicht 421, die an die n-Typ Tunnelübergangsschicht 41 angrenzt, um eine undotierte GaN-Schicht. Diese weist beispielsweise eine Dicke von etwa 2 nm auf. In Wachstumsrichtung nachfolgend ist vorliegend eine zweite undotierte Zwischenschicht 422 angeordnet, die an die p-Typ Tunnelübergangsschicht 43 angrenzt. Bei der zweiten undotierten Zwischenschicht 422 handelt es sich beispielsweise um eine undotierte AlGaN-Schicht. Diese hat zum Beispiel eine Schichtdicke von etwa 1 nm bis etwa 8 nm.

Der zwei- oder mehrschichtige Aufbau des undotierten Bereichs 42 ermöglicht es vorteilhaft, die undotierten Zwischenschichten 421, 422 hinsichtlich ihres Materials und ihrer Dicke an die Diffusionseigenschaften des Dotierstoffs der jeweils angrenzenden Tunnelübergangsschicht 41, 43 anzupassen. Beispielsweise eignet sich die AlGaN-Schicht 422 besonders gut als Diffusionsbarriere für den p-Dotierstoff oder die p-Dotierstoffe der p-Typ Tunnelübergangsschicht 43, insbesondere Magnesium. Die GaN-Schicht 421 eignet sich besonders gut als Diffusionsbarriere für den n-Dotierstoff oder die n-Dotierstoffe der n-Typ-Tunnelübergangsschicht 41, insbesondere Silizium. Zusätzlich wirkt die mindestens eine zusätzliche Grenzfläche bei dem zwei- oder mehrschichtigen Aufbau des undotierten Bereichs 42 als zusätzliche Diffusionsbarriere für die Dotierstoffe der n-Typ und p-Typ Tunnelübergangsschichten 41,43.

Bei einer Variante weist der undotierte Bereich 42 neben einer undotierten Zwischenschicht 421 eine oder mehrere p-dotierte Zwischenschichten 422 auf. Bei einer vorteilhaften Ausgestaltung ist die p-dotierte Zwischenschicht 422 oder zumindest eine p-dotierte Zwischenschicht 422 zwischen zwei undotierten Zwischenschichten 421 angeordnet. Bei dieser Variante ist die Position des Tunnelübergangs besonders genau einstellbar.

In Wachstumsrichtung dem Tunnelübergang 4 nachfolgend ist eine p-dotierte Einschlussschicht 5 angeordnet. Beispielsweise stellt die p-dotierte Einschlussschicht eine Ladungsträger-Einschlussschicht ("confinement layer") und/oder eine Mantelschicht ("cladding layer") dar. Bei einer Ausgestaltung handelt es sich bei der p-dotierten Einschlussschicht 5 um eine p-dotierte AlₓGa₁₋ₓN-Schicht mit 0 ≤ x ≤ 0,1. Die Schichtdicke der p-dotierten Einschlussschicht 5 beträgt zum Beispiel zwischen 50 und 500 nm, vorzugsweise beträgt sie etwa 100 nm. Bei einer bevorzugten Ausgestaltung ist sie mit Magnesium als p-Dotierstoff p-dotiert, beispielsweise liegt der p-Dotierstoff in einer Konzentration zwischen einschließlich 10¹⁸ cm⁻³ und einschließlich 5x10²⁰ cm⁻³, bevorzugt zwischen einschließlich 2x10¹⁹ cm⁻³ und einschließlich 2x10²⁰ cm⁻³, vor.

In Wachstumsrichtung auf die p-dotierte Einschlussschicht 5 folgend ist die aktive Zone 7 angeordnet. Bei einer vorteilhaften Weiterbildung ist zwischen der p-dotierten Einschlussschicht 5 und der aktiven Zone 7 eine Diffusionsbarriere 6 angeordnet. Die Diffusionsbarriere 6 verringert mit Vorteil die Gefahr eines Eindringens des p-Dotierstoffs der p-dotierten Einschlussschicht 5 in die aktive Zone 7.

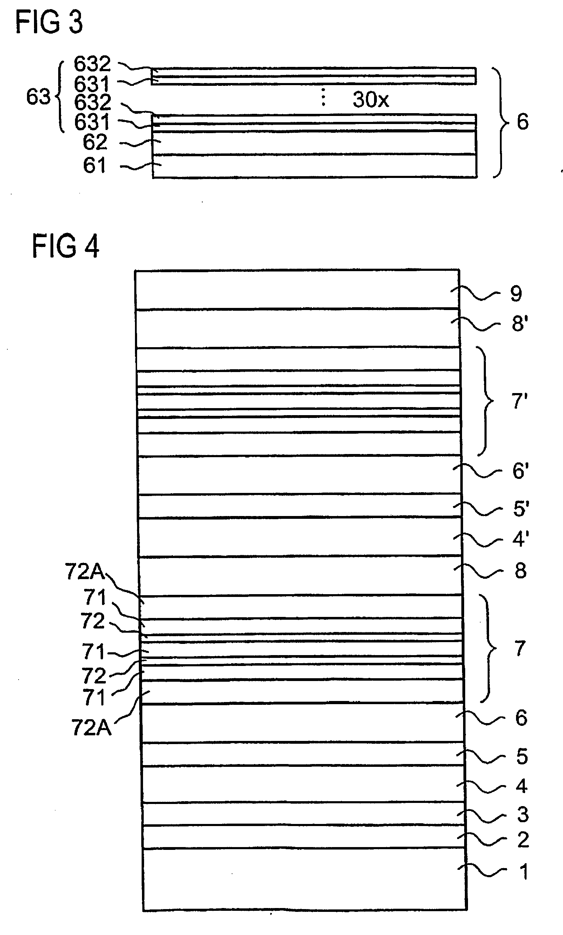

In Figur 3 ist ein vorteilhaftes Ausführungsbeispiel der Diffusionsbarriere 6 dargestellt. Gemäß dem Ausführungsbeispiel der Figur 3 ist die Diffusionsbarriere 6 eine Schichtenfolge aus mehreren Diffusionsbarriereschichten 61, 62, 63.

Bei der ersten Diffusionsbarriereschicht 61, die dem Substrat 1 benachbart ist, handelt es sich beispielsweise um eine undotierte Schicht, insbesondere aus AlGaN, die vorzugsweise eine Schichtdicke von 10 nm oder weniger, beispielsweise von 5 nm aufweist.

Auf die erste Diffusionsbarriereschicht 61 folgt in Wachstumsrichtung eine zweite Diffusionsbarriereschicht 62, die vorzugsweise ebenfalls undotiert ist und insbesondere auf GaN basiert. Die Schichtdicke der zweiten Diffusionsbarriereschicht beträgt beispielsweise etwa 20 nm.

Als dritte Diffusionsbarriereschicht 63, die der zweiten Diffusionsbarriereschicht 62 in Wachstumsrichtung nachfolgt, weist die Diffusionsbarriere 6 ein Übergitter aus alternierenden ersten und zweiten Schichten 631, 632 auf. Beispielsweise handelt es sich um Schichten unterschiedlicher Materialzusammensetzung, etwa alternierenden InGaN-Schichten 631 und GaN-Schichten 632. Das Übergitter weist bevorzugt zehn Schichtpaare 631, 632 oder mehr auf, vorzugsweise weist es 30 Paare oder mehr von ersten und zweiten Schichten 631, 632 auf.

Vorliegend nimmt der Indiumanteil der InGaN-Schichten 631 in Wachstumsrichtung kontinuierlich oder stufenweise ab. Die Schichtdicke der ersten und/oder zweiten Schichten 631, 632 ist vorzugsweise kleiner oder gleich 2 nm, besonders bevorzugt kleiner oder gleich 1 nm. Vorliegend haben die ersten und zweiten Schichten 631, 632 jeweils eine Schichtdicke von 0,5 Nanometer. Die Gesamtdicke der dritten Barriereschicht 63 beträgt vorzugsweise zwischen einschließlich 2 nm und einschließlich 100 nm, vorliegend beträgt sie 30 nm.

Die aktive Zone 7 stellt eine Mehrfachquantentopfstruktur dar. Sie umfasst mehrere aktive Schichten 71, zwischen denen jeweils eine Barriereschicht 72 angeordnet ist. Jeweils eine weitere Barriereschicht 72A geht der ersten aktiven Schicht 71 voraus und folgt der letzten aktiven Schicht 71 in Wachstumsrichtung nach.

Die aktiven Schichten 71 enthalten beispielsweise InGaN oder bestehen daraus. Die Schichtdicke der aktiven Schichten 71 ist zum Beispiel größer oder gleich 0,8 nm und insbesondere kleiner oder gleich 10 nm, bevorzugt hat die Schichtdicke einen Wert zwischen einschließlich 1,8 nm und einschließlich 5 nm.

Die Barriereschichten 72 enthalten zum Beispiel AlInGaN oder bestehen daraus. Sie haben insbesondere eine Schichtdicke zwischen 1 nm und 20 nm, vorzugsweise zwischen 2 und 12 nm, wobei die Grenzen jeweils eingeschlossen sind. Vorzugsweise handelt es sich bei den Barriereschichten 72 um GaN-Schichten. Insbesondere Barriereschichten 72, die GaN-Schichten sind, haben vorzugsweise eine Schichtdicke von kleiner oder gleich 7 nm, besonders bevorzugt von kleiner oder gleich 4 nm.

Nachfolgend auf die aktive Zone 7 ist eine undotierte Halbleiterschicht, die insbesondere eine n-leitende Einschlussschicht 8 darstellt, beispielsweise eine undotierte GaN-Schicht, angeordnet. Die undotierte Halbleiterschicht hat beispielsweise eine Schichtdicke zwischen 3 nm und 40 nm, insbesondere zwischen 3 nm und 15 nm, wobei die Grenzen jeweils eingeschlossen sind.

Der n-leitenden Einschlussschicht folgt an der vom Substrat abgewandten Oberseite des Halbleiterkörpers eine weitere n-Kontaktschicht 9 nach. Bei der weiteren n-Kontaktschicht 9 handelt es sich zum Beispiel um eine Schichtenfolge aus einer der aktiven Zone 7 zugewandten n-dotierten GaN Schicht, beispielsweise mit einer Schichtdicke von etwa 120 nm, und einer von der aktiven Zone abgewandten n-dotierten, inbesondere hoch n-dotierten InGaN-Schicht, die beispielsweise eine Schichtdicke von etwa 5 nm aufweist. Beispielsweise ist die n-dotierte GaN Schicht mit Si in einer Konzentration zwischen einschließlich 10¹⁸ cm⁻³ und einschließlich 6x10¹⁹ cm⁻³, vorzugsweise zwischen einschließlich 2x10¹⁸ cm⁻³ und einschließlich 8x10¹⁸ cm⁻³, dotiert. Die n-dotierte InGaN Schicht ist zum Beispiel mit Si in einer Konzentration zwischen einschließlich 10¹⁸ cm⁻³ und einschließlich 10²¹ cm⁻³, vorzugsweise in einer Konzentration größer oder gleich 3x10¹⁹ cm⁻³, dotiert.

Der Halbleiterkörper, bei dem es sich insbesondere um einen Leuchtdiodenchip (LED-Chip) oder um einen Laserdiodenchip handelt, weist also beidseitig n-Kontaktschichten 3, 9 auf. Die elektrische Kontaktierung des Halbleiterkörpers erfolgt beispielsweise an einer von der Halbleiterschichtenfolge abgewandten Seite des Substrats 1 und an der Oberfläche der weiteren n-Kontaktschicht 9. Dazu ist beispielsweise auf die weitere n-Kontaktschicht 9 eine Kontaktmetallisierung, die insbesondere strukturiert ist, und/oder eine transparente leitfähige Schicht, beispielsweise aus einem transparenten leitfähigen Oxid wie Indium-Zinn-Oxid (ITO) oder ZnO aufgebracht.

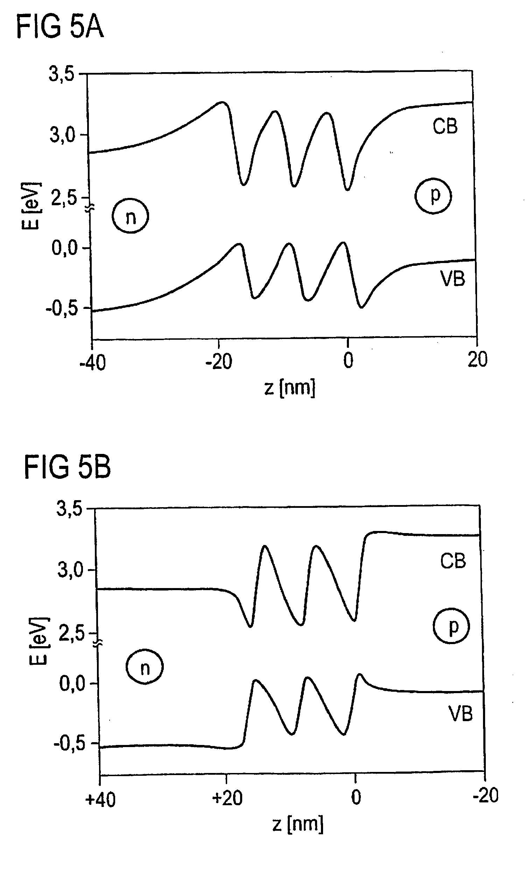

In Figur 5B ist ein Energieniveauschema der Mehrfachquantentopfstruktur 7 des Halbleiterkörpers gemäß dem Ausführungsbeispiel der Figur 1 mit einem Tunnelübergang 4 gemäß Figur 2 und einer Diffusionsbarriere 6 gemäß Figur 3 dargestellt. Figur 5A zeigt im Vergleich dazu die gleiche Quantentopfstruktur in einem Halbleiterkörper ohne Tunnelübergang. Die Energie E von Valenzband VB und Leitungsband CB ist entlang der vertikalen Achsen der Figuren in Elektronenvolt (eV) aufgetragen.

Die horizontale Achse gibt jeweils die relative Position z innerhalb der Halbleiterschichtenfolge in Nanometer (nm) an. Der Wert der Position z nimmt mit dem Abstand vom Substrat 1 zu. Bei der Quantentopfstruktur der Figur 5A ist also das Aufwachssubstrat auf der n-Seite angeordnet. Die n-Seite ist in der Figur mit dem Buchstaben n markiert und links von der Quantentopfstruktur angeordnet. In Figur 5B ist das Aufwachssubstrat auf der mit dem Buchstaben p markierten p-Seite - in der Figur rechts - angeordnet.

Bei dem Halbleiterkörper ohne Tunnelübergang müssen die Ladungsträger beim Übergang von der n-leitenden Einschlussschicht in die aktive Zone beziehungsweise von der p-dotierten Einschlussschicht in die aktive Zone hohe energetische Potentialbarrieren überwinden. Diese entsprechen den starken Anstiegen ungefähr an den Positionen -20 Nanometer und +5 Nanometer in Figur 5A. Bei dem Halbleiterkörper mit dem Tunnelübergang 4 treten solche Potentialbarrieren nicht oder kaum auf.

Zusätzlich zeigt ein Vergleich der Figuren 5A und 5B, dass bei der aktiven Zone in dem Halbleiterkörper mit Tunnelübergang 4 (Figur 5B) die Tiefe der Quantentöpfe leicht reduziert ist und ihre Form deutlich von der Form der Quantentöpfe gemäß Figur 5A unterscheidet. Auf diese Weise ist die effektive Dicke der Potentialbarrieren zwischen den Quantentöpfen bei der aktiven Zone 7 in dem Halbleiterkörper mit Tunnelübergang 4 reduziert. So wird ein Tunneln von Ladungsträgern zwischen den Quantentöpfen erleichtert und eine homogenere Verteilung der Ladungsträger auf die einzelnen Quantentöpfe erzielt.

Mittels Berechnung der Elektronendichte konnte gezeigt werden, dass bei dem in Figur 5A dargestellten Halbleiterkörper ohne Tunnelübergang die höchste Elektronendichte in der Nähe der Grenzfläche zwischen der aktiven Zone und der p-dotierten Einschlussschicht auftritt, entsprechend etwa der Position 0 nm in Figur 5A. Dies erlaubt Elektronen, auf der p-Seite nicht-strahlend zu rekombinieren.

Bei dem Halbleiterkörper gemäß Figur 5B hingegen ist die Elektronenkonzentration in der Nähe der Grenzfläche der aktiven Zone 7 zur n-leitenden Einschlussschicht 8 am größten, entsprechend einer Position zwischen etwa 15 und 20 nm in Figur 5B. Die Gefahr einer nicht strahlenden Rekombination von Elektronen ist dadurch mit Vorteil verringert, was sich besonders bei hohen Betriebsströmen, und damit insbesondere bei hohen Ladungsträgerkonzentrationen, vorteilhaft auf die Effizienz des Halbleiterkörpers auswirkt.

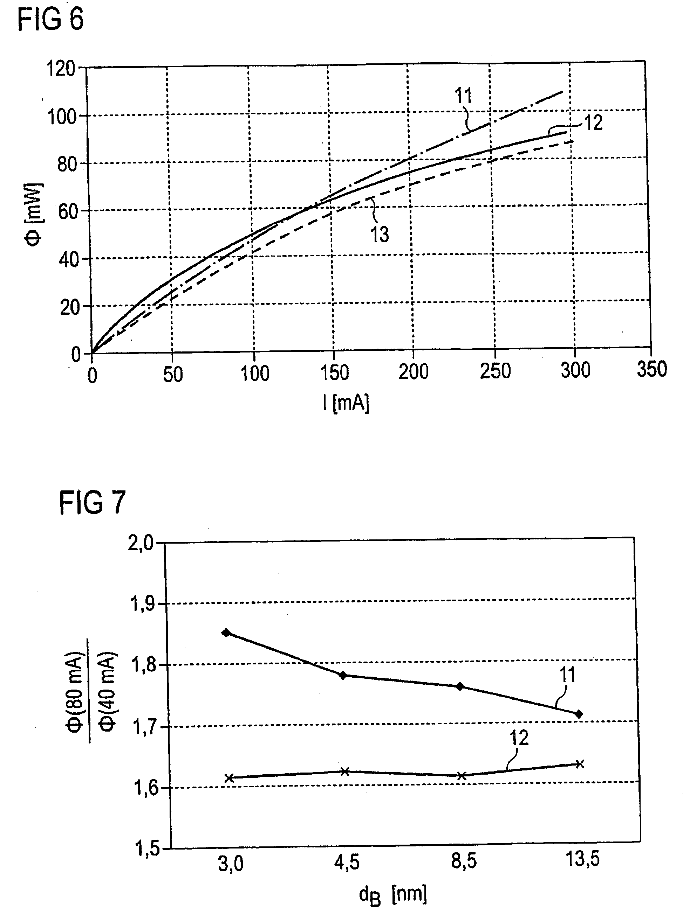

In Figur 6 ist die die Strahlungsleistung Φ des von verschiedenen Halbleiterkörpern emittierten Lichts in Abhängigkeit vom jeweiligen Betriebsstrom I dargestellt.

Die Kurve 11 zeigt die Strahlungsleistung Φ des Halbleiterkörpers gemäß dem Ausführungsbeispiel der Figur 1 in Abhängigkeit vom Betriebsstrom I. Im Vergleich dazu sind die Strahlungsleistungen Φ in Abhängigkeit vom Betriebsstrom I für einen Halbleiterkörper mit einer Mehrfachquantentopfstruktur aber ohne Tunnelübergang, Kurve 12, und für einen Halbleiterkörper mit Tunnelübergang und Einfachquantentopfstruktur, Kurve 13, dargestellt. Bei den vorliegenden Halbleiterkörpern entspricht ein Betriebsstrom I von 100 mA im Wesentlichen einer Betriebsstromdichte von 200 A/cm². Der in der Figur 6 dargestellte Bereich von 0 bis 350 mA entspricht damit einem Bereich der Betriebsstromdichte von 0 bis etwa 700 A/cm².

Weder der Halbleiterkörper mit einer Mehrfachquantentopfstruktur aber ohne Tunnelübergang noch der Halbleiterkörper mit Tunnelübergang und Einfachquantentopfstruktur erreicht bei Betriebsströmen I oberhalb von etwa 150 mA die Effizienz des erfindungsgemäßen Halbleiterkörpers.

Während bei den Linien 12 und 13 eine starke Sättigung eintritt, verläuft die Linie 11, die zu dem Ausführungsbeispiel gemäß der Figur 1 gehört, bei hohen Betriebsströmen I nahezu linear.

Aus der Figur 6 geht - insbesondere aufgrund des fast identischen Verlaufs der Kurven 12 und 13 - auch hervor, dass bei dem Halbleiterkörper ohne Tunnelübergang mit Mehrfachquantentopfstruktur nur einer der Quantentöpfe der Mehrfachquantentopfstruktur zur Emission beiträgt.

Erst die Kombination von Barriereschichten 72 mit geringen Schichtdicken, der Verringerung der Potentialbarrieren in der Mehrfachquantentopfstruktur durch den Einsatz eines Tunnelübergangs 4 im Halbleiterkörper und die Verteilung der Strahlungsemission auf mehrere Quantentöpfe 71 mit einer gleichmäßigen Verteilung der Ladungsträger auf die aktiven Schichten 71 führt zu einer gesteigerten Effizienz der Emissionsintensität bei hohen Stromdichten.

Figur 7 zeigt, dass tatsächlich nur bei einer genügend geringen Schichtdicke der Barriereschichten 72 ein im Wesentlichen linearer Verlauf der Strahlungsleistung Φ des vom Halbleiterkörper emittierten Lichts in Abhängigkeit von der Betriebsstromstärke I erreicht wird.

Bei dem Halbleiterkörper mit Mehrfachquantentopfstruktur ohne Tunnelübergang spielt die Schichtdicke d_{B} der Barriereschichten praktisch keine Rolle (Kurve 12). Das Verhältnis der Strahlungsleistung bei einem Betriebsstrom von 80 mA, Φ(80 mA), zur Intensität bei einem Betriebsstrom von 40 mA, Φ(40 mA), zeigt mit einem Wert von etwa 1,6 bei allen Schichtdicken d_{B} eine starke Sättigung an.

Dagegen steigt bei dem Halbleiterkörper gemäß dem Ausführungsbeispiel der Figuren 1 und 5B das Verhältnis dieser Strahlungsleistungen, Φ(80 mA)/Φ(40 mA), mit abnehmender Schichtdicke d_{B} der Barriereschichten 72 stark an. Das Verhältnis von etwa 1,8 oder mehr bei Schichtdicken d_{B} der Barriereschichten 72 von 4 nm oder weniger, wie sie bei dem vorliegenden Ausführungsbeispiel realisiert sind, indiziert eine verbesserte Linearität und damit eine höhere Effizienz der Emissionsintensität des Halbleiterkörpers bei hohen Betriebsströmen I.

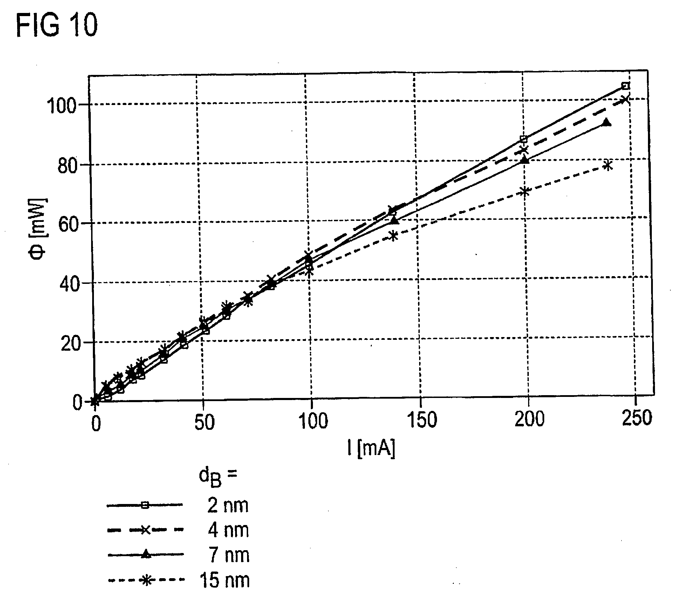

Dies ist in Figur 10 nochmals verdeutlicht. In dieser Figur ist die Abhängigkeit der Strahlungsleistung Φ vom Betriebsstrom I für den Halbleiterkörper gemäß dem Ausführungsbeispiel der Figur 1 mit Barriereschichten 72 gezeigt, die Schichtdicken d_{B} von 2 nm, 4 nm, 7 nm und 15 nm aufweisen. Die Effizienz ist bei hohen Betriebsströmen I erhöht, wenn die Barriereschichten 72 eine Schichtdicke d_{B} von 7 nm oder weniger, bevorzugt von 4 nm oder weniger und insbesondere von 2 nm oder weniger aufweisen.

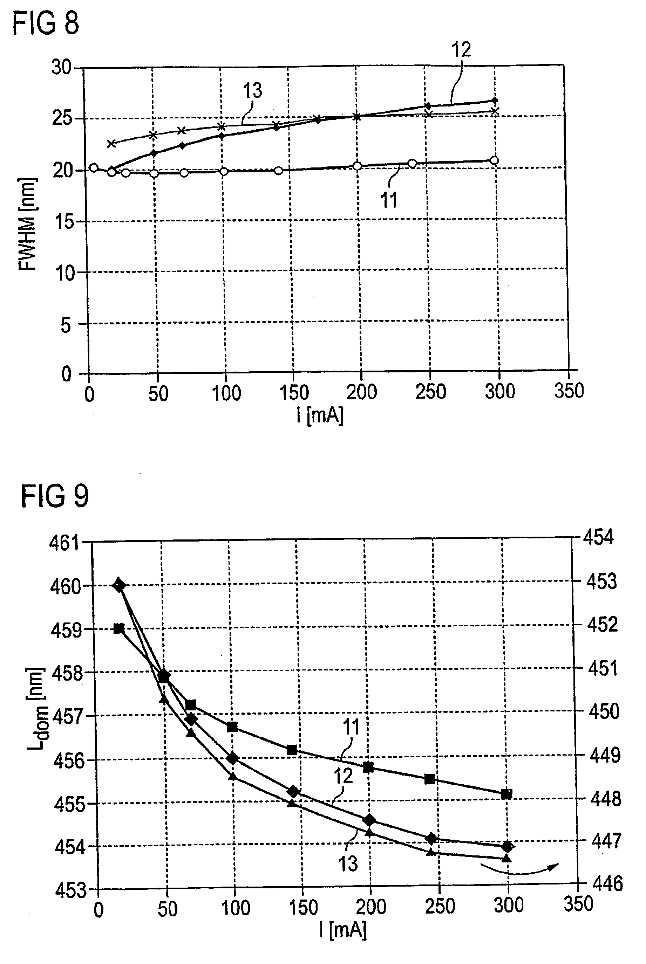

Figur 8 zeigt die Halbwertsbreiten FWHM der von verschiedenen Halbleiterkörpern emittierten elektromagnetischen Strahlung. Kurven 11, 12 und 13 gehören wie Figur 6 zu einem Halbleiterkörper gemäß dem Ausführungsbeispiel der Figur 1 (Kurve 11), zu einem Halbleiterkörper mit einer Mehrfachquantentopfstruktur aber ohne Tunnelübergang (Kurve 12) und einem Halbleiterkörper mit Tunnelübergang und Einfachquantentopfstruktur (Kurve 13).

Die Halbwertsbreite FWHM der Strahlung des Halbleiterkörpers gemäß dem Ausführungsbeispiel der Figur 1 ist im Gegensatz zu den Halbwertsbreiten FWHM der Strahlung der anderen Halbleiterkörper praktisch unabhängig vom Betriebsstrom I. Der Halbleiterkörper gemäß einer der vorstehend beschriebenen Ausgestaltungen ist daher besonders gut für eine Hochleistungslaserdiode geeignet.

Figur 9 zeigt die Abhängigkeit der Wellenlänge L_{dom} des Intensitätsmaximums der von verschiedenen Halbleiterkörpern emittierten Strahlung vom Betriebsstrom I. Während sich die Wellenlänge L_{dom} bei dem Halbleiterkörper mit einer Mehrfachquantentopfstruktur aber ohne Tunnelübergang (Kurve 12) und dem Halbleiterkörper mit Tunnelübergang und Einfachquantentopfstruktur (Kurve 13) mit dem Betriebsstrom I stark verschiebt, ist die Änderung der Wellenlänge L_{dom} des Intensitätsmaximums mit dem Betriebsstrom I bei dem Halbleiterkörper gemäß dem Ausführungsbeispiel der Figur I (Kurve 11) vorteilhaft weniger stark ausgeprägt.

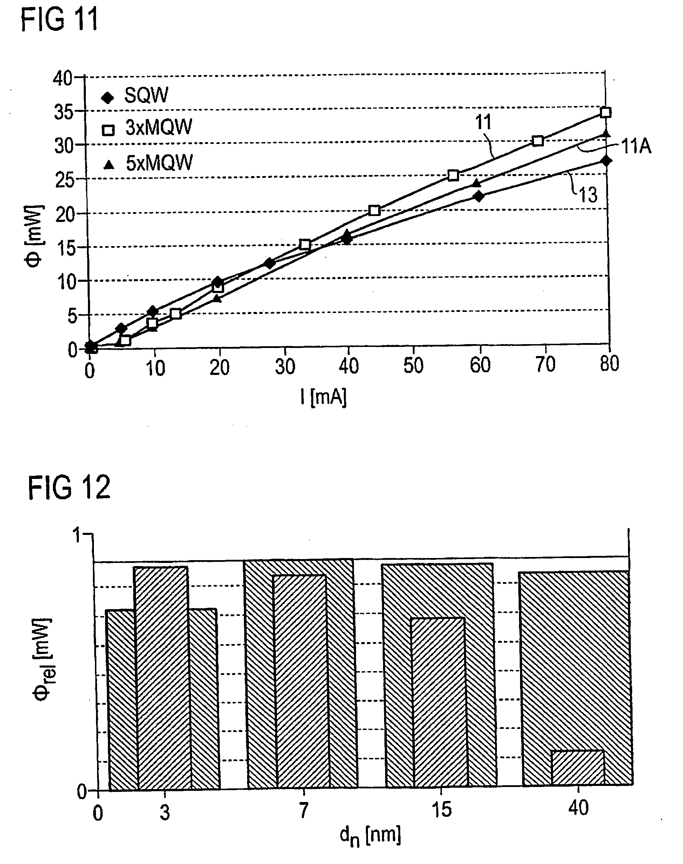

Aus Figur 11 ist ersichtlich, dass die Effizienz des Halbleiterkörpers bei hohen Betriebsströmen I von der Anzahl der Quantentöpfe der Quantentopfstruktur abhängt. Bei einer Schichtdicke d_{B} der Barriereschicht 72 von 4 nm, wie bei dem Halbleiterkörper gemäß dem Ausführungsbeispiel der Figur 1 ist eine aktive Zone 7 mit einer Mehrfachquantentopfstruktur mit genau drei aktiven Schichten 71 besonders effizient. Die Strahlungsleistung Φ der von diesem Halbleiterkörper bei Betriebsströmen I oberhalb von etwa 40 mA emittierten elektromagnetischen Strahlung ist bei einer Mehrfachquantentopfstruktur mit drei Mehrfachquantentöpfen ("3xMQW") maximal (Kurve 11)

Eine weitere Erhöhung der Anzahl der aktiven Schichten 71 bewirkt keine weitere Verbesserung der Strahlungsleistung Φ der emittierten Strahlung. Beispielsweise ist die Strahlungsleistung Φ des Halbleiterkörpers mit einer Mehrfachquantentopfstruktur mit 5 aktiven Schichten 71 ("5xMQW", Kurve 11A) sogar etwas geringer als diejenige des Halbleiterkörpers mit einer Mehrfachquantentopfstruktur mit drei aktiven Schichten 71 (Kurve 11).

Derzeit wird von den Erfindern angenommen dass dies darauf zurückzuführen ist, dass die Breite der aktiven Zone dann größer ist als die Breite des Gebiets, in dem die Ladungsträger rekombinieren können. Die Erhöhung der Anzahl von Quantentöpfen führt dann nicht zu einer Erhöhung der Anzahl der im Betrieb Strahlung emittierenden aktiven Schichten 71. Bei einer geringeren Schichtdicke d_{B} der Barriereschichten 72, beispielsweise einer Schichtdicke von zwei Nanometer oder weniger, kann es jedoch zweckmäßig sein, eine Mehrfachquantentopfstruktur mit mehr als drei aktiven Schichten 71 vorzusehen, beispielsweise mit vier oder fünf aktiven Schichten 71. Die geringere Ausdehnung der aktiven Zone in Wachstumsrichtung hat dann zur Folge, dass in diesem Fall alle vier oder fünf Schichten im Betrieb des Halbleiterkörpers elektromagnetische Strahlung emittieren.

Der Halbleiterkörper mit einer Einfachquantentopfstruktur ("SQW") emittiert bei Betriebsströmen I oberhalb von etwa 40 mA Licht mit der geringsten Strahlungsleistung Φ (Kurve 13), wodurch nochmals belegt wird, dass bei den Halbleiterkörpern mit Mehrfachquantentopfstruktur und Tunnelübergang 4 mehrere der aktiven Schichten 71 zur Strahlungsemission beitragen.

In Figur 12 ist die Abhängigkeit der von dem Halbleiterkörper gemäß dem Ausführungsbeispiel der Figur 1 im Betrieb emittierten relativen Strahlungsleistung Φᵣₑₗ von der Schichtdicke dₙ der undotierten, n-leitenden Schicht 8 dargestellt (breite Balken). Im Vergleich dazu ist die relative Strahlungsleistung Φᵣₑₗ für einen Halbleiterkörper mit Mehrfachquantentopfstruktur und ohne Tunnelübergang zwischen dem Substrat und der aktiven Zone gezeigt (schmale Balken).

Während bei letzterem die Strahlungsleistung Φᵣₑₗ der emittierten elektromagnetischen Strahlung mit zunehmender Schichtdicke dₙ der undotierten n-leitenden Schicht stark abnimmt, zeigt der Halbleiterkörper gemäß dem Ausführungsbeispiel der Figur 1 mit Vorteil nur eine geringe Abhängigkeit der Strahlungsleistung Φᵣₑₗ der im Betrieb emittierten elektromagnetischen Strahlung von der Schichtdicke dₙ der undotierten, n-leitenden Schicht.

Figur 4 zeigt ein weiteres exemplarisches Ausführungsbeispiel eines Halbleiterkörpers. Gemäß diesem Ausführungsbeispiel enthält der Halbleiterkörper zwischen der n-leitenden Einschlussschicht 8 und der n-Kontaktschicht 9 einen weiteren Tunnelübergang 4', eine weitere p-dotierte Einschlussschicht 5', eine weitere Diffusionsbarriere 6', eine weitere aktive Zone 7' und eine weitere n-leitende Einschlussschicht 8', die in Richtung von der n-leitenden Einschlussschicht 8 zur n-Kontaktschicht 9 in dieser Reihenfolge aufeinander folgen.

Der weitere Tunnelübergang 4', die weitere p-dotierte Einschlussschicht 5', die weitere Diffusionsbarriere 6', die weitere aktive Zone 7' und die weitere n-leitende Einschlussschicht 8' sind vorliegend gleich ausgeführt wie der Tunnelübergang 4, die p-dotierte Einschlussschicht 5, die Diffusionsbarriere 6, die aktive Zone 7 und die n-leitende Einschlussschicht 8. Die Ausführung der einzelnen Schicht entspricht zum Beispiel den Ausgestaltungen, die im Zusammenhang mit dem Ausführungsbeispiel der Figuren 1 bis 3 beschrieben sind.

## Patentansprüche

1. Strahlungsemittierender Halbleiterkörper mit einer Kontaktschicht (3) und einer aktiven Zone (7), wobei der Halbleiterkörper einen zwischen der Kontaktschicht und der aktiven Zone angeordneten Tunnelübergang (4) aufweist, wobei die aktive Zone eine Mehrfachquantentopfstruktur aufweist, die mindestens zwei aktive Schichten (71) enthält, die bei Einprägen eines Betriebsstroms in den Halbleiterkörper elektromagnetische Strahlung emittieren, wobei der Tunnelübergang mindestens eine n-Typ Tunnelübergangsschicht (41) und mindestens eine p-Typ Tunnelübergangsschicht (43) aufweist, wobei zwischen der mindestens einen n-Typ Tunnelübergangsschicht (41) und der mindestens einen p-Typ Tunnelübergangsschicht (43) ein undotierter Bereich (42) enthalten ist, **dadurch gekennzeichnet, dass** der undotierte Bereich (42) mindestens zwei Zwischenschichten (421, 422) mit unterschiedlicher Zusammensetzung aufweist.

2. Halbleiterkörper nach Anspruch 1, bei dem zwischen zwei aktiven Schichten (71) eine Barriereschicht (72) angeordnet ist, die eine Schichtdicke (d_{B}) von kleiner oder gleich 9 nm hat.

3. Halbleiterkörper nach einem der vorhergehenden Ansprüche, der 3 oder mehr aktive Schichten (71) und 5 oder weniger aktive Schichten (71) aufweist.

4. Halbleiterkörper nach einem der vorhergehenden Ansprüche, bei dem zumindest die aktive Zone (7) auf einem Nitrid-III-Verbindungshalbleitermaterial basiert.

5. Halbleiterkörper nach einem der vorhergehenden Ansprüche, bei dem die Kontaktschicht (3) eine n-Kontaktschicht ist.

6. Halbleiterkörper nach Anspruch 5, bei dem mindestens die folgenden Halbleiterschichten in der angegebenen Reihenfolge in Wachstumsrichtung aufeinander folgen:
- die n-Kontaktschicht (3),
- der Tunnelübergang (4), wobei die mindestens eine p-Typ Tunnelübergangsschicht (43) dem undotierten Bereich (42) und dieser der mindestens einen n-Typ Tunnelübergangsschicht (41) in Wachstumsrichtung nachfolgt,
- eine p-dotierte Einschlussschicht (5),
- die aktive Zone (7), und
- eine weitere n-Kontaktschicht (9).

7. Halbleiterkörper nach einem der vorhergehenden Ansprüche, bei dem die n-Typ Tunnelübergangsschicht (41) und/oder die p-Typ Tunnelübergangsschicht (43) ein Übergitter aus alternierenden Schichten (431, 432) mit unterschiedlicher Materialzusammensetzung und/oder Dotierstoffkonzentration enthält.

8. Halbleiterkörper nach einem der vorhergehenden Ansprüche mit einer p-dotierten Einschlussschicht (5), bei dem zwischen der p-dotierten Einschlussschicht und der aktiven Zone (7) eine Diffusionsbarriere (6) für den p-Dotierstoff der p-dotierten Einschlussschicht angeordnet ist, die ein Übergitter enthält.

9. Halbleiterkörper nach einem der vorhergehenden Ansprüche, der auf der von dem Tunnelübergang (4) abgewandten Seite der aktiven Zone (7) eine undotierte Zwischenschicht (8) aufweist, die eine Schichtdicke (dₙ) zwischen 3 und 40 nm hat.

10. Halbleiterkörper nach einem der vorhergehenden Ansprüche, der zum Betrieb mit einer Betriebsstromdichte von größer oder gleich 100 A/cm², insbesondere von größer oder gleich 200 A/cm² vorgesehen ist.

11. Halbleiterkörper nach einem der vorhergehenden Ansprüche, der im Betrieb mit einem Betriebsstrom elektromagnetische Strahlung emittiert, die eine spektralen Verteilung mit einem Intensitätsmaximum aufweist, wobei die Halbwertsbreite (FWHM) der spektralen Verteilung im Wesentlichen unabhängig von der Stromstärke (I) des Betriebsstroms ist.

12. Halbleiterkörper nach einem der vorhergehenden Ansprüche, der einen weiteren Tunnelübergang (4') und eine weitere aktive Zone (7') enthält, die der aktiven Zone (7) in Wachstumsrichtung nachfolgen.

## Claims

1. Radiation-emitting semiconductor body comprising a contact layer (3) and an active zone (7), wherein the semiconductor body has a tunnel junction (4) arranged between the contact layer and the active zone, wherein the active zone has a multiple quantum well structure containing at least two active layers (71) which emit electromagnetic radiation when an operating current is impressed into the semiconductor body, wherein the tunnel junction has at least one n-type tunnel junction layer (41) and at least one p-type tunnel junction layer (43), wherein an undoped region (42) is contained between the at least one n-type tunnel junction layer (41) and the at least one p-type tunnel junction layer (43), **characterized in that** the undoped region (42) has at least two interlayers (421, 422) having different compositions.

2. Semiconductor body according to claim 1, wherein a barrier layer (72) having a layer thickness (d_{B}) of less than or equal to 9 nm is arranged between two active layers (71).

3. Semiconductor body according to any of the preceding claims, which has three or more active layers (71) and five or fewer active layers (71).

4. Semiconductor body according to any of the preceding claims, wherein at least the active zone (7) is based on a nitride III compound semiconductor material.

5. Semiconductor body according to any of the preceding claims, wherein the contact layer (3) is an n-type contact layer.

6. Semiconductor body according to claim 5, wherein at least the following semiconductor layers succeed one another in the specified order in the growth direction:
- the n-type contact layer (3),
- the tunnel junction (4), wherein the at least one p-type tunnel junction layer (43) succeeds the undoped region (42) and the latter succeeds the at least one n-type tunnel junction layer (41) in the growth direction,
- a p-doped confinement layer (5),
- the active zone (7), and
- a further n-type contact layer (9).

7. Semiconductor body according to any of the preceding claims, wherein the n-type tunnel junction layer (41) and/or the p-type tunnel junction layer (43) contains a superlattice composed of alternating layers (431, 432) having different material compositions and/or dopant concentrations.

8. Semiconductor body according to any of the preceding claims comprising a p-doped confinement layer (5), wherein there is arranged between the p-doped confinement layer and the active zone (7) a diffusion barrier (6) for the p-type dopant of the p-doped confinement layer, which contains a superlattice.

9. Semiconductor body according to any of the preceding claims, which has an undoped interlayer (8) having a layer thickness (dₙ) of between 3 and 40 nm on that side of the active zone (7) which is remote from the tunnel junction (4).

10. Semiconductor body according to any of the preceding claims, which is provided for operation with an operating current density of greater than or equal to 100 A/cm², in particular of greater than or equal to 200 A/cm².

11. Semiconductor body according to any of the preceding claims, which, during operation with an operating current, emits electromagnetic radiation having a spectral distribution with an intensity maximum, wherein the full width at half maximum (FWHM) of the spectral distribution is substantially independent of the current intensity (I) of the operating current.

12. Semiconductor body according to any of the preceding claims, which contains a further tunnel junction (4') and a further active zone (7'), which succeed the active zone (7) in the growth direction.

## Revendications

1. Corps semi-conducteur émetteur de rayonnement pourvu d'une couche de contact (3) et d'une zone active (7), dans lequel le corps semi-conducteur comporte une jonction tunnel (4) disposée entre la couche de contact et la zone active, dans lequel la zone active comporte une structure à puits quantiques multiples qui contient au moins deux couches actives (71) qui émettent un rayonnement électromagnétique lorsqu'un courant de fonctionnement est appliqué au corps semi-conducteur, dans lequel la jonction tunnel comporte au moins une couche de jonction tunnel de type n (41) et au moins une couche de jonction tunnel de type p (43), dans lequel une région non dopée (42) est contenue entre l'au moins une couche de jonction tunnel de type n (41) et l'au moins une couche de jonction tunnel de type p (43), **caractérisé en ce que** la région non dopée (42) comporte au moins deux couches intermédiaires (421, 422) ayant des compositions différentes.

2. Corps semi-conducteur selon la revendication 1, dans lequel il est prévu entre deux couches actives (71) une couche barrière (72) qui a une épaisseur de couche (d_{B}) inférieure ou égale à 9 nm.

3. Corps semi-conducteur selon l'une quelconque des revendications précédentes, comportant trois couches actives (71) ou plus, et cinq couches actives (71) ou moins.

4. Corps semi-conducteur selon l'une quelconque des revendications précédentes, dans lequel la zone active (7) est à base d'au moins un matériau semi-conducteur composite de nitrure III.

5. Corps semi-conducteur selon l'une quelconque des revendications précédentes, dans lequel la couche de contact (3) est une couche de contact n.

6. Corps semi-conducteur selon la revendication 5, dans lequel au moins les couches semi-conductrices suivantes se suivent les unes les autres selon la séquence indiquée, dans la direction de croissance:
- la couche de contact n (3),
- la jonction tunnel (4), dans lequel l'au moins une couche de jonction tunnel de type p (43) suit la région non dopée (42) et cette dernière suit l'au moins une couche de jonction tunnel de type n (41) dans la direction de croissance,
- une couche de confinement dopée p (5),
- la zone active (7), et
- une autre couche de contact n (9).

7. Corps semi-conducteur selon l'une quelconque des revendications précédentes, dans lequel la couche de jonction tunnel de type n (41) et/ou la couche de jonction tunnel de type p (43) contiennent un superréseau constitué de couches alternées (431, 432) ayant des compositions de matériau et/ou des concentrations en matériau dopant différentes.

8. Corps semi-conducteur selon l'une quelconque des revendications précédentes, comportant une couche de confinement dopée p (5), dans lequel il est prévu entre la couche de confinement dopée p et la zone active (7) une barrière de diffusion (6) destinée au matériau dopant de la couche de confinement dopée p qui contient un superréseau.

9. Corps semi-conducteur selon l'une quelconque des revendications précédentes, qui comporte, sur la face de la zone active (7) qui est opposée à la jonction tunnel (4), une couche intermédiaire non dopée (8) qui présente une épaisseur de couche (dₙ) comprise entre 3 et 40 nm.

10. Corps semi-conducteur selon l'une quelconque des revendications précédentes, qui est prévu pour être utilisé avec une densité de courant de fonctionnement supérieure ou égale à 100 A/cm², et plus particulièrement, supérieure ou égale à 200 A/cm².

11. Corps semi-conducteur selon l'une quelconque des revendications précédentes, qui émet, lors d'un fonctionnement avec un courant de fonctionnement, un rayonnement électromagnétique qui présente une distribution spectrale ayant un maximum d'intensité, dans lequel la largeur à mi-hauteur (FWHM) de la distribution spectrale est sensiblement indépendante de l'intensité (I) du courant de fonctionnement.

12. Corps semi-conducteur selon l'une quelconque des revendications précédentes, contenant une autre jonction tunnel (4') et une autre zone active (7') qui suivent la zone active (7) dans la direction de croissance.
